(19) Europäisches Patentamt
European Patent Office
Office européen des brevets

(11) **EP 3 373 403 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **17160188.3**

(22) Anmeldetag: **09.03.2017**

(51) Int Cl.:
*G01R 15/16* (2006.01)    *H02H 3/14* (2006.01)
*H02H 5/00* (2006.01)    *H02H 11/00* (2006.01)
*H02H 3/33* (2006.01)    *H02H 1/00* (2006.01)
*G01R 19/155* (2006.01)    *G01R 31/02* (2006.01)
*H02H 5/10* (2006.01)

(54) **DI-SCHUTZSCHALTEINRICHTUNG UND BETRIEBSVERFAHREN ZUR ERKENNUNG EINER SPANNUNG AUF DEM PEN-LEITER**

DIFFERENTIAL CURRENT PROTECTION AND OPERATION METHOD FOR DETECTING A VOLTAGE ON THE PEN CONDUCTOR

COUPE-CIRCUIT DI ET PROCÉDÉ DE FONCTIONNEMENT POUR DÉTECTER UNE TENSION SUR LE CONDUCTEUR PEN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**12.09.2018 Patentblatt 2018/37**

(73) Patentinhaber: **Heinrich Kopp GmbH**
**63796 Kahl am Main (DE)**

(72) Erfinder: **SCHUCK, Nicolas**
**63743 Aschaffenburg (DE)**

(74) Vertreter: **Metten, Karl-Heinz**
**Boehmert & Boehmert**
**Anwaltspartnerschaft mbB**
**Pettenkoferstrasse 22**
**80336 München (DE)**

(56) Entgegenhaltungen:
**EP-B1- 0 806 825**    **DE-A1-102012 219 542**
**DE-A1-102016 105 882**    **DE-B3-102010 050 767**
**DE-B3-102013 212 739**

**Beschreibung**

Die Erfindung geht aus von einer DI-Schutzschalteinrichtung mit den Merkmalen des Oberbegriffs des Patentanspruchs 1. Eine derartige Schutzschalteinrichtung ist aus der EP 0 806 825 B1 bekannt.

Bei den aus dem Stand der Technik bekannten DI-Schutzschalteinrichtungen weist die Erkennungseinrichtung einen durch einen Benutzer berührbaren Sensor mit einer Sensorfläche aus einem leitfähigen Material auf, die bei Berührung durch den Benutzer auf Erdpotential gezogen wird, sofern durch die Berührung der erforderliche elektrische Kontakt zwischen der Hand des Benutzers und der Sensorfläche hergestellt wird. Die Erkennungseinrichtung ist mit dem Schutzleiter elektrisch verbunden, so dass bei Berührung über die Erfassung eines Spannungsabfalls zwischen der elektrisch leitfähigen Sensorfläche und dem Schutzleiter darauf geschlossen werden kann, ob der Schutzleiter spannungsfrei ist.

Die bekannten DI-Schutzschalteinrichtungen haben jedoch den Nachteil, dass sie auch ein elektrisch isoliertes Einschalten ermöglichen, beispielsweise indem ein Benutzer einen elektrisch nicht leitfähigen oder nur schlecht leitfähigen Handschuh trägt, sodass die genannte Sicherheitsfunktion unwirksam wird. Weiterhin können auf diese Weise auch nicht ausreichend niederohmige Schutzleiter als "gut" erkannt. Die vorhandene Sensorik reicht somit nicht aus, um insbesondere bei der Verwendung von Schutzbekleidung (Handschuhe, Schuhe, etc.) eine sichere Detektion des Schutzleiterzustands zu erzielen und insbesondere die Spannungsfreiheit dieses zu gewährleisten.

Die DE 10 2012 219 542 A1 betrifft eine Schutzleiterüberwachungsvorrichtung umfassend einen Bezugspotentialerzeuger zum Bereitstellen eines Bezugspotentials (UR) aus Spannungspotentialen eines ersten Stromversorgungsleiters und/oder eines zweiten Stromversorgungsleiters; einen Prüfstromerzeuger zum Erzeugen eines Prüfstroms (IP), der von dem Bezugspotential (UR) abhängig ist; eine Erfassungsvorrichtung zum Erzeugen einer Größe (φ), die von dem Prüfstrom (IP) abhängig ist; und eine Auswertevorrichtung zum Auswerten der von der Erfassungsvorrichtung erzeugten Größe (φ). Hierbei hat der Bezugspotentialerzeuger mindestens eine Kapazität und/oder mindestens eine Diode aufzuweisen. Die Schutzleiterüberwachungsvorrichtung der DE 10 2012 219 542 A1 soll einen geringeren Energieverbrauch aufweisen als die bekann-ten Schutzleiterüberwachungsvorrichtungen. Auch soll mithilfe dieser Schutzleiterüberwachungsvorrichtungen geprüft werden können, ob ein Schutzleiter spannungsführend ist, ohne dass der Benutzer bei der Schutzleiterprüfung mit einem Teil in Berührung kommt, das mit dem möglicherweise spannungsführenden Schutzleiter elektrisch verbunden ist.

Es ist daher die Aufgabe der Erfindung, die eingangs beschriebene DI-Schutzschalteinrichtung derart weiter zu entwickeln, dass sie auch dann eine zuverlässige Schutzleiterüberprüfung erlaubt, wenn die DI-Schutzschalteinrichtung elektrisch isoliert betätigt wird.

Diese Aufgabe löst eine DI-Schutzschalteinrichtung mit den Merkmalen des Anspruchs 1. Der nebengeordnete Anspruch 12 betrifft ein entsprechendes Betriebsverfahren. Die abhängigen Ansprüche sind jeweils auf vorteilhafte Ausführungsformen der Erfindung ausgerichtet.

Demgemäß ist vorgesehen, dass die Erkennungseinrichtung einen kapazitiven Sensor aufweist, der bei Berührung durch einen Benutzer einen elektrischen Kondensator mit einem kapazitiven Blindwiderstand gegenüber dem Erdpotential bildet, wobei die Erkennungseinrichtung weiterhin eine Auswerteelektronik, beispielsweise einen Mikrocontroller, aufweist, die dazu eingerichtet ist, durch Schalten des Sensors gegen den Phasenleiter und getrennt davon gegen den Nullleiter eine Position des Phasenleiters zu bestimmen, wobei von der Auswerteelektronik auf das Nicht-Vorhandensein einer Phasenspannung auf dem Schutzleiter geschlossen wird, wenn von der Auswerteelektronik bei an dem Phasenleiter anliegender Phase Spannungsfreiheit zwischen dem Nullleiter und dem Schutzleiter ermittelt ist.

Die bei den Schutzschalteinrichtungen aus dem Stand der Technik verwendete elektrisch leitfähige Sensorfläche wird somit durch eine kapazitive ersetzt, wodurch keine direkte, elektrisch leitfähige Verbindung mit der Sensorfläche mehr hergestellt werden muss. Um ein auswertbares Signal erzeugen zu können, sollte der Sensor vorteilhaft so ausgelegt werden, dass selbst bei dicker Schutzkleidung ein ausreichend großes Sensorsignal vorhanden ist. Ausgangspunkt des Sensorprinzips ist der Plattenkondensator, der sich gemäß

$$C = \frac{\varepsilon A}{d} \qquad\qquad \text{(Gleichung 1)}$$

berechnen lässt. Es ist wünschenswert, eine große Sensorkapazität zu erhalten, damit sich über den daraus resultierenden kapazitiven Blindwiderstand

$$X_C = \frac{1}{j\,\omega\,C} \qquad\qquad \text{(Gleichung 2)}$$

ein möglichst großer Strom einstellt. Dieser Sensorstrom darf jedoch nicht in einer Größenordnung liegen, in welcher der Benutzer geschädigt wird, wobei insbesondere eine Stromstärke von wenigen Mikroampere angestrebt werden sollte.

So kann es vorgesehen sein, dass eine Außenseite eines dielektrischen Gehäuses der DI-Schutzschalteinrichtung bei Berührung durch einen Benutzer mit einem elektrischen Leiter den Kondensator bildet. Der elektrische Leiter kann beispielsweise in einem Gehäusezwischenraum aufgenommen sein, auf der Gehäuseaußenseite aufgebracht sein, oder eine Beschichtung der Innenseite des Gehäuses sein oder aufweisen.

Zur Erzielung einer möglichst großen Kontaktfläche zwischen der Hand eines Benutzers und dem Gehäuse und dementsprechend zur Erzielung einer großen effektiven Kondensatorfläche A kann vorgesehen sein, dass die Außenseite des Gehäuses insoweit ergonomisch ausgeformt ist, als dass ein großflächiger Kontakt zwischen der Hand oder dem die Hand umhüllenden Handschuh und der Gehäuseaußenseite eines Benutzers hergestellt wird, wenn der Benutzer das Gehäuse mit der Hand oder dem Handschuh umfasst. Der Kondensator kann über den elektrischen Leiter mit einer Spannung beaufschlagt werden. Insbesondere kann dazu der elektrische Leiter mit der Erkennungseinrichtung elektrisch verbunden sein. Wenn die Kapazität des Kondensators gemäß Gleichung 1 bestimmt ist, kann $\varepsilon$ die Permittivität des Dielektrikums und d dessen Dicke sein, welche die Summe aus einer Gehäusedicke, einer menschlichen Hautdicke, eventueller Lufteinschlüsse und gegebenenfalls einer Handschuhmaterialdicke sein kann, und wobei A die durch die Berührung des Benutzers überdeckte Fläche des elektrischen Leiters an der Innenseite sein kann.

Es ist vorteilhaft, das Gehäuse der DI-Schutzschalteinrichtung oder zumindest des elektrischen Leiters an der Innenseite des Gehäuses auf mindestens $3 \times 10^{-3} \mathrm{m}^2$ zu vergrößern, was ungefähr der Fläche von zwei Händen entspricht. Die Gehäuseoberfläche sollte weiterhin möglichst plan an den Händen des Benutzers anliegen, so dass das Gehäuse zumindest an seiner Außenseite, mit der der Benutzer in Kontakt kommt, eine ergonomische Geometrie aufweisen kann.

Die Auswerteelektronik kann insbesondere dazu eingerichtet sein, eine Phasenposition auf dem Phasenleiter und dem Nullleiter zu bestimmen, indem sie nacheinander den Phasenleiter und den Nullleiter gegen den Sensor schaltet und jeweils auf das Vorliegen eines Spannungsabfalls prüft. Es kann somit vorgesehen sein, anstatt den Schutzleiter direkt zu prüfen, wie es die aus dem Stand der Technik bekannten Vorrichtungen vorsehen, zunächst nacheinander die Leiter L(N) und N(L) gegen den kapazitiven Sensor zu schalten. Abhängig von den erhaltenen Signalen, mithin qualitativ erfassten Spannungsabfällen (ja/nein), wird ausgewertet, ob eine nächste Prüfphase eingeleitet werden kann. Nach Auswertung der erhaltenen Signale kann die Phase einer Position auf dem N-Leiter oder dem L-Leiter zugeordnet werden. Demgemäß kann die Auswerteelektronik dazu eingerichtet sein, über die qualitativ erfassten Spannungsabfälle an dem Phasenleiter und dem Nullleiter entsprechend der nachstehenden Wahrheitstabelle die Phasenposition zu ermitteln:

| L(N) $\leftrightarrow$ Sensor | N(L) $\leftrightarrow$ Sensor | Phasenposition |
|---|---|---|
| 0 | 0 | nicht feststellbar |
| 0 | 1 | N(L) |
| 1 | 0 | L(N) |
| 1 | 1 | nicht feststellbar |

Im Anschluss daran können die Phase und der Nullleiter gegen den Schutzleiter geprüft werden. Dabei kann insbesondere beobachtet werden, ob die Potenzialdifferenz zwischen dem Nullleiter und dem Schutzleiter unterhalb eines zulässigen Wertes für eine Berührspannung liegt, beispielsweise unterhalb von 50V.

Demgemäß kann die Auswerteelektronik weiterhin dazu eingerichtet sein, in Kenntnis der Phasenposition den Phasenleiter gegen den Schutzleiter und den Nullleiter gegen den Schutzleiter auf einen Spannungsabfall zu prüfen, wobei die Auswerteelektronik nur dann auf einen ordnungsgemäßen Schutzleiter schließt, wenn bei entsprechend der bestimmten Phasenposition gegenüber dem Phasenleiter ein Spannungsabfall anliegt und gegenüber dem Nullleiter Spannungsfreiheit vorliegt oder ein Spannungsabfall unterhalb einer Berührspannung liegt.

Die Auswerteelektronik kann dazu eingerichtet sein, über die Prüfung des Phasenleiters gegen den Schutzleiter und des Nullleiters gegen den Schutzleiter auf einen Spannungsabfall entsprechend der nachstehenden Wahrheitstabelle einen Zustand des Schutzleiters zu ermitteln:

| Phase $\leftrightarrow$ PE | Nullleiter $\leftrightarrow$ PE | PE-Zustand |
|---|---|---|
| 0 | 0 | nicht vorhanden o. hochohmig |
| 0 | 1 | spannungsführend |
| 1 | 0 | vorhanden und spannungsfrei |

(fortgesetzt)

| Phase ↔ PE | Nullleiter ↔ PE | PE-Zustand |
|---|---|---|
| 1 | 1 | Funktion nicht vorhanden |

Sollte die Überprüfung der Potenzialdifferenz zwischen dem Nullleiter und dem Schutzleiter ergeben haben, dass sie unterhalb einer zulässigen Berührspannung liegt, so kann anschließend von der Auswerteelektronik eine Überprüfung der Schutzleitergüte durchgeführt werden, insbesondere eine Überprüfung auf Niederohmigkeit des Schutzleiters.

Ist auch dieser Gütetest bestanden, kann von der Erkennungseinrichtung ein Freigabesignal an eine Schaltstufe zur Steuerung eines DI-Schalters weitergeleitet und damit der Ausgang der DI-Schutzschalteinrichtung zugeschaltet werden.

Gemäß einem anderen Aspekt betrifft die Erfindung ein Verfahren für den Betrieb einer DI-Schutzschalteinrichtung der zuvor beschriebenen Art, wobei das Verfahren die Schritte aufweist:

- Berühren des Sensors der DI-Schutzschalteinrichtung mit einer Hand, die gegebenenfalls von einem Handschutz umhüllt ist, wobei ein elektrischer Kondensator mit einem kapazitiven Blindwiderstand gegenüber dem Erdpotential gebildet wird;

- nacheinander Schalten des Phasenleiters und des Nullleiters gegen den Sensor und Ermitteln einer Phasenposition daraus;

- in Kenntnis der Phasenposition Prüfen des Phasenleiters gegen den Schutzleiter und des Nullleiter gegen den Schutzleiter auf einen Spannungsabfall;

- Schließen von Schaltkontakten des Phasenleiter, des Nullleiter und des Schutzleiters nur dann, wenn das Prüfen ergeben hat, dass der Schutzleiter vorhanden/niederohmig und/oder spannungsfrei ist.

Das Verfahren kann weiterhin das Umgreifen eines Gehäuses der DI-Schutzschalteinrichtung aufweisen, wobei das Umgreifen derart erfolgen soll, dass eine möglichst große Kontaktfläche zwischen der Hand oder dem Handschuh eines Benutzers und der Außenseite des Gehäuses hergestellt wird. Um dies zu fördern, kann vorgesehen sein, dass das Gehäuse an seiner Außenseite ergonomisch ausgeformt ist.

Weitere Einzelheiten der Erfindung werden anhand der nachstehenden Figuren erläutert. Dabei zeigt:

Figur 1 schematisch den Aufbau eines kapazitiven Sensors zur Verwendung in einer erfindungsgemäßen DI-Schutzschalteinrichtung gemäß einer Ausführungsform; und

Figur 2 ein Blockschaltbild einer DI-Schutzschalteinrichtung gemäß einer Ausführungsform der Erfindung.

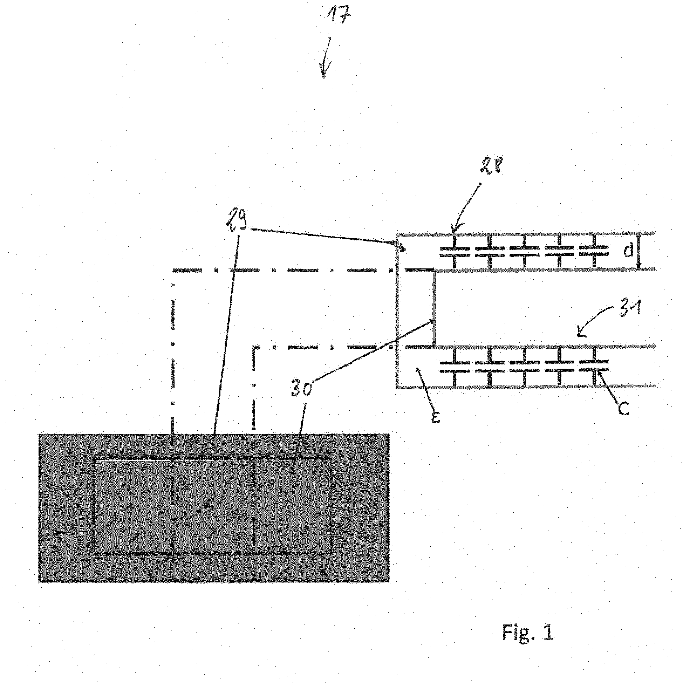

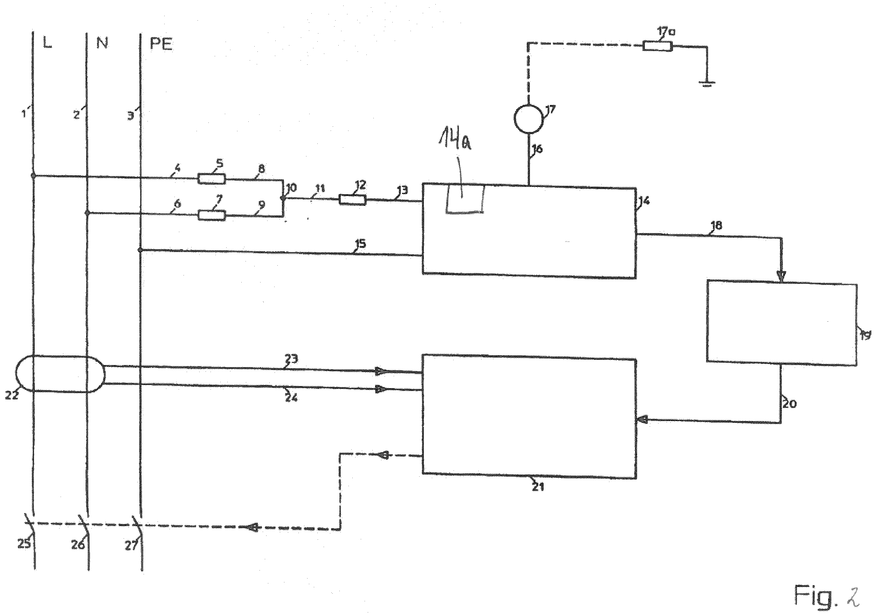

Figur 1 zeigt schematisch den Aufbau eines kapazitiven Sensors 17 zur Verwendung in einer erfindungsgemäßen DI-Schutzschalteinrichtung gemäß einer Ausführungsform der Erfindung. Demgemäß ist der Sensor 17 im Wesentlichen durch das Gehäuse 29 der DI-Schutzschalteinrichtung gebildet, wobei das Gehäuse 29 an seiner Innenseite 31 einen elektrischen Leiter 30 aufweist. Der elektrische Leiter 30 kann beispielsweise eine metallische Beschichtung der Innenseite 31 des Gehäuses 29 sein. Der elektrische Leiter 30 kann mit der Auswerteelektronik 14a der Erkennungseinrichtung 14 verbunden sein, um erfindungsgemäß gegen den Phasenleiter oder den Nullleiter zwecks Bestimmung der Phasenposition geschaltet zu werden (siehe Figur 2). Das Gehäuse 29 weist eine Oberfläche 28 auf, die von einem Anwender mit der Hand umschlossen werden kann. Sie stellt eine erste Elektrode des mit dem Leiter 31 gebildeten Kondensators dar. Das Gehäusematerial der Dicke d bildet dabei das Dielektrikum des Kondensators und weist eine Permittivität $\varepsilon$ auf. Die Permittivität beschreibt die dielektrische Leitfähigkeit des Gehäusematerials.

Die Fläche des elektrischen Leiters 30 an der Innenseite 31 des Gehäuses 29 stellt die maximal verfügbare Sensorfläche dar, wobei die effektiv realisierte kapazitive Fläche A gerade durch die Überschneidung der von der Hand eines Anwenders umschlossenen Gehäuseoberfläche 28 und der Sensorfläche A definiert ist. Die Dicke d des Gehäuses 29 bildet somit weiterhin gerade den Abstand der Kondensatorplatten zueinander. Die effektive Kapazität und damit die Sensorkapazität lässt sich aus den oben genannten Werten anhand der Gleichung für den Plattenkondensator Gleichung 1 berechnen. Dies kann näherungsweise wie nachstehend beschrieben erfolgen.

In dem nun folgenden Beispiel wird vereinfacht die Sensorkapazität zwischen der Sensorfläche und der Hand ermittelt. Die angegebene Fläche entspricht der effektiven kapazitiven Fläche des Sensors 17. Die Permittivität $\varepsilon$ wird

als Parameter vernachlässigt, um das Augenmerk auf die Sensorgeometrie zu lenken. Es wird für die oberste Hautschicht die gleiche Permittivität wie für den Handschuh angenommen. Es gilt:

•

$$\varepsilon = 1\frac{F}{m}$$

• Für die Dicke der obersten Hautschicht $d_1$ werden $30 \cdot 10^{-6}$ m angenommen;

• Für die Dicke eines Handschuhs $d_2$ wird $7 \cdot 10^{-3}$m angenommen;

• für die Gehäusedicke wird ca. 1 mm angenommen

• Die Fläche eines Daumens $A_1$ entspricht ca. $(20 \cdot 10^{-3}\text{m}) \cdot (20 \cdot 10^{-3}\text{m}) = 400 \cdot 10^{-6}$ m$^2$;

• Die Fläche einer Hand $A_2$ entspricht ca. $(150 \cdot 10^{-3}\text{m}) \cdot (100 \cdot 10^{-3}\text{m}) = 15 \cdot 10^{-3}$m$^2$.

Setzt man die Werte von $d_1$ und $A_1$ in die Gleichung 1 ein betrachtet man den Fall: Daumen ohne Handschuh auf Sensor.

$$C_1 = \frac{\varepsilon A_1}{d_1} = \frac{1F \cdot \left(400 \cdot 10^{-6} m^2\right)}{m \cdot (30 \cdot 10^{-6}\ m)} = 13,\overline{3}F \qquad (3)$$

Wird nun $d_1$ durch $d_2$ ersetzt, erhält man den Fall: Daumen mit Handschuh auf Sensor.

$$C_1 = \frac{\varepsilon A_1}{d_2} = \frac{1F \cdot \left(400 \cdot 10^{-6} m^2\right)}{m \cdot (7 \cdot 10^{-3}\ m)} = 0,0\overline{571428}F \qquad (4)$$

Geht man nun von einer Serienschaltung von Hautkapazität $C_1$ und Handschuhkapazität $C_2$ aus, ergibt sich folgende Gesamtkapazität.

$$C_{ges1} = \frac{1}{\frac{1}{C_1}+\frac{1}{C_2}} = \frac{1}{\frac{1}{13,\overline{3}F}+\frac{1}{0,0571428\,F}} \approx 0,0569\ F \qquad (5)$$

Setzt man nun das Ergebnis ohne Handschuh von Gleichung 3 und das Ergebnis mit Handschuh von Gleichung 5 in ein Verhältnis zueinander, ergibt sich folgender Wert

$$\frac{C_1}{C_{ges1}} \approx \frac{13,\overline{3}\,F}{0,0569\,F} \approx 234,33 \qquad (6)$$

Da sich die Kapazität C indirekt proportional zum Blindwiderstand $X_c$ verhält, verschlechtert eine geringere Sensorkapazität den Sensorstrom (ausgehend vom Ohm'schen Gesetz). Eine höhere Kapazität hat demnach einen höheren Sensorstrom zur Folge. Führt man die gleiche Kapazitätsberechnung (Gleichung 5 bis Gleichung 6) mit $A_2$ und $d_2$ durch, erhält man für das neue Verhältnis folgendes Ergebnis

$$\frac{C_1}{C_{ges2}} \approx \frac{13,\overline{3}\,F}{1,846\,F} \approx 7,22 \qquad (7)$$

Bei gleicher Sensorfläche wird somit das Sensorsignal bei Verwendung eines Handschuhs um den Faktor 234,33 schlechter (unabhängig von den Materialkonstanten). Wird die Sensorfläche auf die Größe der Handfläche erhöht, verschlechtert sich das Signal mit Handschuh lediglich noch um den Faktor 7,22 im Vergleich zu den aus dem Stand der Technik bekannten Daumensensoren mit entsprechend kleiner Sensorfläche. Demnach kann der Handschuh durch die Sensorfläche teilweise kompensiert werden. Für eine vollständige Kompensation müsste die Fläche im vorliegenden Fall auf 93,33 x $10^{-3}$m$^2$ erhöht werden. Dieser Parameter wird jedoch von der Handflächengröße des Anwenders begrenzt, da nur die Überschneidung von Hand- und Sensorfläche als wirksame Fläche gilt.

Es ist daher vorteilhaft, die effektive Sensorfläche auf die Größe von zwei Händen, beispielsweise auf $30 \cdot 10^{-3} m^2$ zu vergrößern. Die Gehäuseoberfläche 28 sollte weiterhin möglichst plan an den Händen des Anwenders anliegen, so dass ein ergonomisches Design der Gehäuseoberfläche 28 bevorzugt wird.

Figur 2 zeigt ein Blockschaltbild einer bevorzugten Ausführungsform der erfindungsgemäßen DI-Schutzschalteinrichtung. Bei dieser ist der L-Phasenleiter 1 über eine Leitung 4 an eine Schutzimpedanz 5 und der Nullleiter 2 über eine Leitung 6 an eine Schutzimpedanz 7 angeschlossen. Die Schutzimpedanzen 5, 7 sind ausgangsseitig über Leiter 8, 9 an einem Knotenpunkt 10 zusammengeschaltet. Der Knotenpunkt 10 ist über eine Leitung 11 an eine weitere Schutzimpedanz 12 angeschlossen, welche ausgangsseitig über einen Leiter 13 mit einer Einrichtung 14 zur Erkennung des Schutzleiterzustandes verbunden ist. Die Schutzimpedanzen 5, 7 und 12 dienen der Strombegrenzung. Die Einrichtung 14 ist ferner über eine Leitung 15 an den Schutzleiter 3 und über eine Leitung 16 an einen Sensor 17 angeschlossen. Der Sensor 17 ist erfindungsgemäß ein kapazitiver Sensor, beispielsweise ein Sensor, wie er mit Bezug auf Figur 1 beschrieben worden ist.

Der Ausgang der Einrichtung 14 ist über einen Leiter 18 mit einer Schaltstufe 19 verbunden, welche über eine Leitung 20 einen DI-Fehlerstromschutzschalter 21 schaltet. Der DI-Fehlerstromschutzschalter 21 ist an einen Summenstromwandler 22 angeschlossen, dessen Primärwicklung durch den Phasenleiter 1 und den Nullleiter 2 gebildet wird. Der Summenstromwandler 22 weist ferner eine Sekundärwicklung auf, die induzierte Spannungen über Leitungen 23, 24 zu einer in dem DI-Schalter 21 enthaltenen Auswertelektronik führt. Der DI-Schalter 21 ist mechanisch mit Schaltkontakten 25, 26, 27 gekoppelt, welche in die Leitungen 1, 2, 3 geschaltet sind.

Je nach Position des Phasenleiters liegt von der Leitung 4 über die Schutzimpedanz 5 und die Leitung 8, oder über die Leitung 6, die Schutzimpedanz 7 und die Leitung 9 ein Stromfluss zu dem Knotenpunkt 10 und von dem Knotenpunkt 10 über den Leiter 11, die Schutzimpedanz 12, den Leiter 13, die Erkennungseinrichtung 14 und die Leitung 15 zum Schutzleiter 3 vor. Im Normalfall, das heißt wenn der Phasenleiter 1, der Neutralleiter 2 und der Schutzleiter 3 korrekt angeschlossen sind, fließt dieser Strom durch die Einrichtung 14 über die Leitung 15 zu dem Schutzleiter 3 ab.

Fehlt jedoch dieser Strom, beispielsweise weil der Schutzleiter nicht angeschlossen oder unterbrochen ist, erkennt die Einrichtung 14 diesen Fehlerzustand aufgrund des nicht über den Leiter 15 zum Schutzleiter 3 abfließenden Stromes und schaltet über eine potenzialmä-ßig getrennte Schaltstufe 19 den DI-Schutzschalter 21, welcher die Schaltkontakte 25, 26, 27 öffnet und somit die Leiter 1, 2, 3 unterbricht.

Die Einrichtung 14 ist darüber hinaus darauf ausgelegt, das Vorhandensein einer Fremdspannung beziehungsweise Netzspannung auf den Schutzleiter 3 zu erkennen. Dazu dient der kapazitive Sensor 17, der bei Berührung durch einen Benutzer einen elektrischen Kondensator mit einem kapazitiven Blindwiderstand gegenüber dem Erdpotential bildet. Die Erkennungseinrichtung 14 weist eine Auswerteelektronik 14a auf, die dazu eingerichtet ist, durch Schalten des Sensors 17 gegen den Phasenleiter 1 und getrennt davon gegen den Nullleiter 2 die Position der Phase zu bestimmen. Anstelle somit, wie dies die Vorrichtungen aus dem Stand der Technik vorgesehen haben, den Schutzleiter direkt zu prüfen, werden zunächst nacheinander der Nullleiter und der Schutzleiter neben dem Sensor geschaltet, um die Phase einer Position auf dem L-Leiter oder dem N-Leiter zuzuordnen. Abhängig von den erhaltenen Signalen wird ausgewertet, ob die nächste Prüfphase eingeleitet werden kann:

| L(N) ↔ Sensor | N(L) ↔ Sensor | Phasenposition |
|---|---|---|
| 0 | 0 | nicht feststellbar |
| 0 | 1 | N(L) |
| 1 | 0 | L(N) |
| 1 | 1 | nicht feststellbar |

Nach Bestimmung der Phasenposition werden die Phase und der Nullleiter gegen den Schutzleiter geprüft. Nach einer Signalauswertung kann beurteilt werden, ob eine Potenzialdifferenz zwischen dem Nullleiter und dem Schutzleiter vorliegt, und falls dies der Fall ist, ob diese unterhalb einer Berührspannung liegt. Eine vernachlässigbare Berührspannung kann beispielsweise angenommen werden, wenn die Potenzialdifferenz <50V beträgt. Die Signalauswertung zur Beurteilung der Potenzialdifferenz zwischen dem Nullleiter und dem PE kann entsprechend der nachstehenden Wahrheitstabelle durchgeführt werden:

| Phase ↔ PE | Nullleiter ↔ PE | PE-Zustand |
|---|---|---|
| 0 | 0 | nicht vorhanden o. hochohmig |
| 0 | 1 | spannungsführend |

(fortgesetzt)

| Phase ↔ PE | Nullleiter ↔ PE | PE-Zustand |
|---|---|---|
| 1 | 0 | vorhanden und spannungsfrei |
| 1 | 1 | Funktion nicht vorhanden |

Im Anschluss daran kann eine Überprüfung der Schutzleitergüte durchgeführt werden, beispielsweise indem ein Widerstand des Schutzleiters ermittelt wird.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. DI-Schutzschalteinrichtung mit einem Summenstromwandler (22) zur Erfassung von Fehlerströmen in einem Phasenleiter (1) und einem Nullleiter (2) und mit einer Erkennungseinrichtung (14) zur Erkennung von Fehlerzuständen eines Schutzleiters (3),

   wobei die Erkennungseinrichtung (14) eingangsseitig mit dem Phasenleiter (1), dem Nullleiter (2) und dem Schutzleiter (3) und ausgangsseitig mit einer Schaltstufe (19) zum Steuern eines DI-Schutzschalters (21) verbunden ist, wobei der DI-Schutzschalter (21) dazu eingerichtet ist, Schaltkontakte (25, 26, 27) in dem Phasenleiter (1), dem Nullleiter (2) und dem Schutzleiter (3) zu schalten,

   wobei die Erkennungseinrichtung (14) als einen Fehlerzustand das Vorhandensein einer Phasenspannung auf dem Schutzleiter (3) erkennt,

   wobei die Erkennungseinrichtung (14) einen kapazitiven Sensor (17) aufweist, der bei Berührung durch einen Benutzer einen elektrischen Kondensator mit einem kapazitiven Blindwiderstand gegenüber dem Erdpotential bildet, dadurch gegenzeichnet, dass die Erkennungseinrichtung (14) weiterhin eine Auswerteelektronik (14a) aufweist, die dazu eingerichtet ist, durch Schalten des Sensors (17) gegen den Phasenleiter (1) und getrennt davon gegen den Nullleiter (2) eine Phasenposition zu bestimmen, wobei von der Auswerteelektronik (14a) auf das Nicht-Vorhandensein einer Phasenspannung auf dem Schutzleiter (3) geschlossen wird, wenn von der Auswerteelektronik (14a) Spannungsfreiheit zwischen dem Nullleiter (2) und dem Schutzleiter (3) ermittelt ist.

2. DI-Schutzschalteinrichtung nach Anspruch 1, **dadurch gekennzeichnet, dass** bei dieser eine Außenseite (28) eines dielektrischen Gehäuses (29) der DI-Schutzschalteinrichtung bei Berührung durch einen Benutzer mit einem elektrischen Leiter (30) des Gehäuses den Kondensator bildet.

3. DI-Schutzschalteinrichtung nach Anspruch 2, **dadurch gekennzeichnet, dass** bei dieser der elektrische Leiter (30) in einem Gehäusezwischenraum aufgenommen ist, auf der Gehäuseaußenseite (28) aufgebracht ist, oder eine Beschichtung der Innenseite (31) des Gehäuses (29) ist oder aufweist.

4. DI-Schutzschalteinrichtung nach Anspruch 2 oder 3, **dadurch gekennzeichnet, dass** bei dieser die Außenseite (28) des Gehäuses (29) insoweit ergonomisch ausgeformt ist, als dass ein großflächiger Kontakt zwischen der Hand oder dem die Hand umhüllenden Handschuh eines Benutzers hergestellt wird, wenn der Benutzer das Gehäuse (29) mit der Hand oder dem Handschuh umfasst.

5. DI-Schutzschalteinrichtung nach einem der Ansprüche 2 bis 4, **dadurch gekennzeichnet, dass** bei dieser der Kondensator über den elektrischen Leiter (30) mit einer Spannung beaufschlagt ist.

6. DI-Schutzschalteinrichtung nach einem der vorangegangenen Ansprüche, **dadurch gekennzeichnet, dass** bei dieser eine Kapazität des Kondensators gemäß $C = \varepsilon A/d$ (Gl. 1) bestimmt ist, wobei $\varepsilon$ die Permittivität des Dielektrikums ist, welche die Summe aus einer Gehäusedicke, einer menschlichen Hautdicke, eventueller Lufteinschlüsse und gegebenenfalls einer Handschuhmaterialdicke ist, und A die durch die Berührung des Benutzers überdeckte Fläche des elektrischen Leiters (30) an der Innenseite (31) ist.

7. DI-Schutzschalteinrichtung nach einem der vorangegangenen Ansprüche, **dadurch gekennzeichnet, dass** bei dieser die Auswerteelektronik (14a) dazu eingerichtet ist, eine Phasenposition auf dem Phasenleiter (1) und dem Nullleiter (2) zu bestimmen, indem er getrennt voneinander den Phasenleiter (1) und den Nullleiter (2) gegen den Sensor (17) schaltet und jeweils auf das Vorliegen eines Spannungsabfalls prüft.

8. DI-Schutzschalteinrichtung nach Anspruch 7, **dadurch gekennzeichnet, dass** bei dieser die Auswerteelektronik (14a) dazu eingerichtet ist, über die qualitativ erfassten Spannungsabfälle an dem Phasenleiter (1) und dem Nullleiter (2) entsprechend der nachstehenden Wahrheitstabelle die Phasenposition zu ermitteln:

| L(N) ↔ Sensor | N(L) ↔ Sensor | Phasenposition |
|---|---|---|
| 0 | 0 | nicht feststellbar |
| 0 | 1 | N(L) |
| 1 | 0 | L(N) |
| 1 | 1 | nicht feststellbar |

9. DI-Schutzschalteinrichtung nach einem der vorangegangenen Ansprüche **dadurch gekennzeichnet, dass** bei dieser der Mikrocontroller weiterhin dazu eingerichtet ist, in Kenntnis der Phasenposition den Phasenleiter (1) gegen den Schutzleiter (3) und den Nullleiter (2) gegen den Schutzleiter (3) auf einen Spannungsabfall zu prüfen, wobei die Auswerteelektronik (14a) nur dann auf einen ordnungsgemäßen Schutzleiter (3) schließt, wenn bei entsprechend der bestimmen Phasenposition gegenüber dem Phasenleiter (1) ein Spannungsabfall anliegt und gegenüber dem Nullleiter (2) Spannungsfreiheit vorliegt oder ein Spannungsabfall unter einer Berührspannung liegt, vorzugsweise unter einer Spannung von 50 V.

10. DI-Schutzschalteinrichtung nach Anspruch 9, **dadurch gekennzeichnet, dass** bei dieser die Auswerteelektronik (14a) dazu eingerichtet ist, über die Prüfung des Phasenleiters (1) gegen den Schutzleiter (3) und des Nullleiters (2) gegen den Schutzleiter (3) auf einen Spannungsabfall entsprechend der nachstehenden Wahrheitstabelle einen Zustand des Schutzleiters (3) zu ermitteln:

| Phase ↔ PE | Nullleiter ↔ PE | PE-Zustand |
|---|---|---|
| 0 | 0 | nicht vorhanden o. hochohmig |
| 0 | 1 | spannungs führend |
| 1 | 0 | vorhanden und spannungsfrei |
| 1 | 1 | Funktion nicht vorhanden |

11. Verfahren für den Betrieb einer DI-Schutzschalteinrichtung nach einem der vorangegangenen Ansprüche, umfassend die Schritte:

- Berühren des Sensors (17) der DI-Schutzschalteinrichtung mit einer Hand, die gegebenenfalls von einem Handschutz umhüllt ist, wobei ein elektrischer Kondensator mit einem kapazitiven Blindwiderstand gegenüber dem Erdpotential gebildet wird;
- getrennt voneinander Schalten des Phasenleiters (1) und des Nullleiters (2) gegen den Sensor (17) und Ermitteln einer Phasenposition daraus;
- in Kenntnis der Phasenposition Prüfen des Phasenleiters (1) gegen den Schutzleiter (3) und des Nullleiters (2) gegen den Schutzleiter (3) auf einen Spannungsabfall; und
- Schließen von Schaltkontakten des Phasenleiters (1), des Nullleiters (2) und des Schutzleiters (3) nur dann, wenn das Prüfen ergeben hat, dass der Schutzleiter vorhanden/niederohmig und/oder spannungsfrei ist.

12. Verfahren nach Anspruch 11, **dadurch gekennzeichnet, dass** dieser das Umgreifen eines Gehäuses (29) der DI-Schutzschalteinrichtung aufweist, so dass eine möglichst große Kontaktfläche zwischen der Hand oder dem Handschuh eines Benutzers und der Außenseite (28) des Gehäuses (29) hergestellt wird.

**Claims**

1. A DI-circuit breaker device with a summation current converter (22) for detecting fault currents in a phase conductor (1) and a neutral conductor (2) and with an identification device (14) for identifying fault states of a protective ground conductor (3),
   wherein the identification device (14) is connected, on the input side, to the phase conductor (1), the neutral conductor (2) and the protective ground conductor (3) and, on the output side, to a switching stage (19) for controlling a DI-circuit breaker (21), wherein the DI-circuit breaker (21) is adapted to switch switching contacts (25, 26, 27) in the phase conductor (1), the neutral conductor (2) and the protective ground conductor (3),
   wherein the identification device (14) identifies the presence of a phase voltage on the protective ground conductor (3) as a fault state,
   wherein the identification device (14) has a capacitive sensor (17) which, when touched by a user, forms an electric capacitor with a capacitive reactance with respect to earth potential, **characterised in that** the identification device (14) further has evaluating electronics (14a) which are adapted to determine a phase position by connecting the sensor (17) to the phase conductor (1) and, separately therefrom, to the neutral conductor (2), wherein the evaluating electronics (14a) conclude the absence of a phase voltage on the protective ground conductor (3) when it is established by the evaluating electronics (14a) that there is no voltage between the neutral conductor (2) and the protective ground conductor (3).

2. The DI-circuit breaker device according to Claim 1, **characterised in that** an outer side (28) of a dielectric housing (29) of the DI-circuit breaker device forms the capacitor with an electrical conductor (30) of the housing upon being touched by a user.

3. The DI-circuit breaker device according to Claim 2, **characterised in that** the electrical conductor (30) is accommodated in a housing gap, attached to the outer side (28) of the housing or is, or has, a coating on the inner side (31) of the housing (29).

4. The DI-circuit breaker device according to Claim 2 or 3, **characterised in that** the outer side (28) of the housing (29) is ergonomically shaped to the extent that a large area contact between a user's hand, or the glove enclosing the hand, is produced when the user grasps the housing (29) with their hand or glove.

5. The DI-circuit breaker device according to any one of Claims 2 to 4, **characterised in that** the capacitor is supplied with a voltage via the electrical conductor (30),

6. The DI-circuit breaker device according to any one of the preceding claims, **characterised in that**
   a capacitance of the capacitor is determined according to $C = \varepsilon A/d$ (Eq. 1), wherein $\varepsilon$ is the permittivity of the dielectric which is the sum of a housing thickness, a thickness of human skin, possible trapped air and, possibly, a glove material thickness, and A is the surface area of the electrical conductor (30) at the inner side (31) covered by the user's touch.

7. The DI-circuit breaker device according to any one of the preceding claims, **characterised in that**
   the evaluating electronics (14a) are adapted to determine a phase position on the phase conductor (1) and neutral conductor (2) by connecting the phase conductor (1) and the neutral conductor (2) to the sensor (17) separately from one another and testing in each case for the presence of a voltage drop.

8. The DI-circuit breaker device according to Claim 7, **characterised in that** the evaluating electronics (14a) are adapted to establish the phase position via the qualitatively detected voltage drops at the phase conductor (1) and the neutral conductor (2) corresponding to the following truth table:

| L(N) ↔ sensor | N(L) ↔ sensor | Phase position |
|---|---|---|
| 0 | 0 | unascertainable |
| 0 | 1 | N(L) |
| 1 | 0 | L (N) |
| 1 | 1 | unascertainable |

9. The DI-circuit breaker device according to any one of the preceding claims, **characterised in that** the microcontroller is further adapted to test the phase conductor (1) against the protective ground conductor (3) and the neutral conductor (2) against the protective ground conductor (3) for a voltage drop with knowledge of the phase position, wherein the evaluating electronics (14a) conclude that the protective ground conductor (3) is operating properly only when a voltage drop is present corresponding to the determined phase position relative to the phase conductor (1) and voltage is absent corresponding to the determined phase position relative to the neutral conductor (2), or a voltage drop lies below a touch voltage, preferably below a voltage of 50 V.

10. The DI-circuit breaker device according to Claim 9, **characterised in that** the evaluating electronics (14a) are adapted to establish a state of the protective ground conductor (3) by testing the phase conductor (1) against the protective ground conductor (3) and the neutral conductor (2) against the protective ground conductor (3) for a voltage drop corresponding to the following truth table:

| Phase ↔ PE | Neutral conductor ↔ PE | PE state |
|---|---|---|
| 0 | 0 | Not present or high-impedance |
| 0 | 1 | Conducting voltage |
| 1 | 0 | Present and voltage-free |
| 1 | 1 | Function not present |

11. A method for the operation of a DI-circuit breaker device according to any one of the preceding claims, comprising the steps:

- touching the sensor (17) of the DI-circuit breaker device with a hand which is possibly enclosed in a glove, wherein an electric capacitor is formed with a capacitive reactance relative to earth potential;
- connecting the phase conductor (1) and the neutral conductor (2) to the sensor (17) separately from one another and establishing a phase position therefrom;
- with the phase position being known, testing the phase conductor (1) against the protective ground conductor (3) and testing the neutral conductor (2) against the protective ground conductor (3) for a voltage drop; and
- closing switching contacts of the phase conductor (1), neutral conductor (2) and protective ground conductor (3) only when the test has shown that the protective ground conductor is present/has low impedance and/or is free of voltage.

12. The method according to Claim 11, **characterised in that** said method includes grasping a housing (29) of the DI-circuit breaker device so that the largest possible contact surface between a user's hand or glove and the outer side (28) of the housing (29) is produced.

**Revendications**

1. Coupe-circuit DI comprenant un transformateur de courant total (22) pour la détermination de courants de défaut dans un conducteur de phase (1) et un conducteur neutre (2) et comprenant un dispositif de détection (14) pour la détection d'états de défaut d'un conducteur de protection (3),
le dispositif de détection (14) étant raccordé du côté de l'entrée avec le conducteur de phase (1), le conducteur neutre (2) et le conducteur de protection (3) et du côté de la sortie avec un étage de commutation (19) pour la commande d'un commutateur de protection DI (21), le commutateur de protection DI (21) étant conçu pour commuter des contacts de commutation (25, 26, 27) dans la conducteur de phase (1), le conducteur neutre (2) et le conducteur de protection (2),
le dispositif de détection (14) détectant en tant qu'état de défaut la présence d'une tension de phase sur le conducteur de protection (3),
le dispositif de détection (14) comprenant un capteur capacitif (17), qui forme lors d'un contact par un utilisateur un condensateur électrique avec une réactance capacitive par rapport au potentiel terrestre, **caractérisé en ce que** le dispositif de détection (14) comprend en outre une électronique d'évaluation (14a), qui est conçue pour déterminer une position de phase par commutation du capteur (17) contre le conducteur de phase (1) et séparément de celui-ci contre le conducteur neutre (2), l'absence d'une tension de phase sur le conducteur de protection (3) étant conclue par l'électronique d'évaluation (14a) lorsqu'une absence de tension est calculée entre le conducteur neutre (2) et le conducteur de protection (3) par l'électronique d'évaluation (14a).

2. Coupe-circuit DI selon la revendication 1, **caractérisé en ce qu'**un côté extérieur (28) d'un boîtier diélectrique (29) du coupe-circuit DI forme le condensateur lors du contact par un utilisateur avec un conducteur électrique (30) du boîtier.

3. Coupe-circuit DI selon la revendication 2, **caractérisé en ce que** le conducteur électrique (30) est reçu dans un espace intermédiaire du boîtier, est appliqué sur le côté extérieur du boîtier (28), ou est ou comprend un revêtement du côté intérieur (31) du boîtier (29).

4. Coupe-circuit DI selon la revendication 2 ou 3, **caractérisé en ce que** le côté extérieur (28) du boîtier (29) est formé ergonomiquement **en ce qu'**un contact de grande surface entre la main ou le gant entourant la main d'un utilisateur est créé lorsque l'utilisateur couvre le boîtier (29) avec la main ou le gant.

5. Coupe-circuit DI selon l'une quelconque des revendications 2 à 4, **caractérisé en ce que** le condensateur est chargé avec une tension par le biais du conducteur électrique (30).

6. Coupe-circuit DI selon l'une quelconque des revendications précédentes, **caractérisé en ce qu'**une capacité du condensateur est déterminée selon C = $\varepsilon$A/d (Eqn. 1), s étant la permittivité du diélectrique, qui est la somme d'une épaisseur de boîtier, d'une épaisseur de peau humaine, d'inclusions d'air éventuelles et éventuellement d'une épaisseur de matériau de gant, et A est la surface du conducteur électrique (30) recouverte par le contact de l'utilisateur sur le côté intérieur (31).

7. Coupe-circuit DI selon l'une quelconque des revendications précédentes, **caractérisé en ce que** l'électronique d'évaluation (14a) est conçue pour déterminer une position de phase sur le conducteur de phase (1) et le conducteur neutre (2), **en ce qu'**il commute séparément l'un de l'autre le conducteur de phase (1) et le conducteur neutre (2) contre le capteur (17) et examine à chaque fois la présence d'une chute de tension.

8. Coupe-circuit DI selon la revendication 7, **caractérisé en ce que** l'électronique d'évaluation (14a) est conçue pour déterminer la position de phase par le biais des chutes de tension déterminées qualitativement sur le conducteur de phase (1) et le conducteur neutre (2) conformément à la table de vérité suivante :

| Capteur $\leftrightarrow$ L(N) $\leftrightarrow$ | Capteur $\leftrightarrow$ N(L) $\leftrightarrow$ | Position de phase |
|---|---|---|
| 0 | 0 | non déterminable |
| 0 | 1 | N(L) |
| 1 | 0 | L (N) |
| 1 | 1 | non déterminable |

9. Coupe-circuit DI selon l'une quelconque des revendications précédentes, **caractérisé en ce que** le microcontrôleur est en outre conçu pour examiner une chute de tension en connaissance de la position de phase du conducteur de phase (1) contre le conducteur de protection (3) et du conducteur neutre (2) contre le conducteur de protection (3), l'électronique d'évaluation (14a) ne concluant alors à un conducteur de protection (3) correct que lorsqu'une chute de tension est présente conformément à la position de phase déterminée par rapport au conducteur de phase (1) et qu'une absence de tension est présente par rapport au conducteur neutre (2) ou une chute de tension en dessous d'une tension de contact, de préférence en dessous d'une tension de 50 V.

10. Coupe-circuit DI selon la revendication 9, **caractérisé en ce que** l'électronique d'évaluation (14a) est conçue pour déterminer un état du conducteur de protection (3) par le biais de l'examen du conducteur de phase (1) contre le conducteur de protection (3) et du conducteur neutre (2) contre le conducteur de protection (3) pour déterminer une chute de tension conformément à la table de vérité suivante :

| Phase H ↔ PE | Conducteur neutre H ↔ PE | État PE |
|---|---|---|
| 0 | 0 | non présent ou de grande valeur ohmique |
| 0 | 1 | sous tension |
| 1 | 0 | présent et exempt de tension |
| 1 | 1 | Fonction non présente |

11. Procédé pour l'exploitation d'un coupe-circuit DI selon l'une quelconque des revendications précédentes, comprenant les étapes suivantes :

   - le contact du capteur (17) du coupe-circuit DI avec une main, qui est éventuellement entourée par une protection de main, un condensateur électrique ayant une réactance capacitive par rapport au potentiel terrestre étant créé ;
   - séparément l'un de l'autre, la commutation du conducteur de phase (1) et du conducteur neutre (2) contre le capteur (17) et la détermination d'une position de phase ;
   - en connaissance de la position de phase, l'examen du conducteur de phase () contre le conducteur de protection (3) et du conducteur neutre (2) contre le conducteur de protection (3) pour déterminer une chute de tension ; et
   - la fermeture de contacts de commutation du conducteur de phase (1), du conducteur neutre (2) et du conducteur de protection (3) uniquement lorsque l'examen a indiqué que le conducteur de protection est présente/à faible valeur ohmique et/ou exempt de tension.

12. Procédé selon la revendication 11, **caractérisé en ce que**
celui-ci comprend l'entourage d'un boîtier (29) du coupe-circuit DI de telle sorte qu'une surface de contact la plus grande possible entre la main ou le gant d'un utilisateur et le côté extérieur (28) du boîtier (29) soit créé.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0806825 B1
- DE 102012219542 A1